(19) Europäisches Patentamt
European Patent Office
Office européen des brevets

(11) **EP 4 535 018 A1**

(12) **EUROPEAN PATENT APPLICATION**

(43) Date of publication:
09.04.2025 Bulletin 2025/15

(21) Application number: 24202748.0

(22) Date of filing: 26.09.2024

(51) International Patent Classification (IPC):
*G01R 31/34* (2020.01)

(52) Cooperative Patent Classification (CPC):
**G01R 31/343**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.10.2023 IN 202341066285**

(71) Applicant: **ABB SCHWEIZ AG**
**5400 Baden (CH)**

(72) Inventors:
• **VALSAN, Simi**
**683108 Aluva (IN)**
• **DASGUPTA, Subhashish**
**560066 Bangalore (IN)**
• **KUMAR, Ranjeet**
**800003 Patna (IN)**
• **GUPTA, Arinjai**
**560093 Bengaluru (IN)**

(74) Representative: **Zimmermann & Partner**
**Patentanwälte mbB**
**Postfach 330 920**
**80069 München (DE)**

(54) **METHOD AND SYSTEM FOR AIR GAP ECCENTRICITY DETECTION IN ROTATING MACHINES**

(57) Embodiments of the present disclosure disclose a method and system (150) for air gap eccentricity detection in a rotating machine (100). The method includes receiving, by a processor (202), external leakage flux measurements of a rotating machine (100) from each of a plurality of magnetic sensors (110a, 110b, 110c, 110d). The method includes determining, by the processor (202), a moving average for the external leakage flux measurements received from each of the plurality of magnetic sensors (110a, 110b, 110c, 110d). The method includes determining, by the processor (202), an air gap eccentricity condition of the rotating machine (100) based on the moving average associated with each of the plurality of magnetic sensors (1 10a, 110b, 110c, 110d).

— 500

RECEIVE, BY A PROCESSOR, EXTERNAL LEAKAGE FLUX MEASUREMENTS OF A ROTATING MACHINE FROM EACH OF A PLURALITY OF MAGNETIC SENSORS — 502

DETERMINE, BY THE PROCESSOR, A MOVING AVERAGE FOR THE EXTERNAL LEAKAGE FLUX MEASUREMENTS RECEIVED FROM EACH OF THE PLURALITY OF MAGNETIC SENSORS — 504

DETERMINE, BY THE PROCESSOR, AN AIRGAP ECCENTRICITY CONDITION OF THE ROTATING MACHINE BASED ON THE MOVING AVERAGE ASSOCIATED WITH EACH OF THE PLURALITY OF MAGNETIC SENSORS — 506

**FIG. 5**

EP 4 535 018 A1

**Description**

## TECHNICAL FIELD

The present disclosure generally relates to rotating machines and more particularly, to a method and system for air gap eccentricity detection in rotating machines.

## BACKGROUND

Rotating machines have been in use for a long time to generate power and as industrial work horses. Despite the sturdy construction, the rotating machines are still prone to faults which can bring a critical process to standstill and cause huge losses. Air gap eccentricity is one of the most common types of faults in the rotating machines. Air gap eccentricity refers to a condition in which a center of a rotor is misaligned with a center of a stator of the rotating machine. More specifically, air gap eccentricity occurs when there is a non-uniform or asymmetric distance between the rotor and stator in the air gap of the rotating machine. Such air gap eccentricity arises due to wear and tear caused by wind, weather and other operating conditions resulting in imbalances causing the air gap between stator and rotor to be non-uniform. The rotating machine operated with an eccentric air gap results in increased mechanical vibration, accelerated insulation degradation due to increased coil movement, and possible rotor/stator rubbing due to unbalanced magnetic pull. If left undetected, the eccentricity can increase slowly and in a worst case, cause the rotor to touch the stator causing a catastrophic failure. From an operation point of view, the air gap must be maintained uniform and kept consistent in order to keep the rotor from getting damaged due to magnetically induced heating, stator frame vibration, increased amplitude of bearings spectrum first harmonic, uneven magnetic field, wear or cracks in construction elements, winding insulation faults, cracks in rotor poles to rim connection, rotor or stator core corrosion, uneven warm-up, bearing faults, etc.

In view of the above discussion, there is a need for early fault detection and warning to ensure all-round protection and proper functioning of the rotating machines.

The information disclosed in this background of the disclosure section is only for enhancement of understanding of the general background of the invention and should not be taken as an acknowledgement or any form of suggestion that this information forms the prior art already known to a person skilled in the art.

## SUMMARY

In an embodiment, a method for determining air gap eccentricity in a rotating machine is disclosed. The method includes receiving, by a processor, external leakage flux measurements of a rotating machine from each of a plurality of magnetic sensors. The method includes determining, by the processor, a moving average for the external leakage flux measurements received from each of the plurality of magnetic sensors. The method includes determining, by the processor, an air gap eccentricity condition of the rotating machine based on the moving average associated with each of the plurality of magnetic sensors.

In another embodiment, a system for determining air gap eccentricity in a rotating machine is disclosed. The system includes a memory and a processor. The memory is configured to store instructions. The processor is configured to execute the instructions stored in the memory and thereby configured to receive an external leakage flux measurements of a rotating machine from a plurality of magnetic sensors. The processor is configured to determine a moving average for the external leakage flux measurements received from each of the plurality of magnetic sensors. The processor is configured to determine an air gap eccentricity condition of the rotating machine based on the moving average associated with each of the plurality of magnetic sensors.

The foregoing summary is illustrative only and is not intended to be in any way limiting. In addition to the illustrative aspects, embodiments, and features described above, further aspects, embodiments, and features will become apparent by reference to the drawings and the following detailed description.

## BRIEF DESCRIPTION OF THE DRAWINGS

The accompanying drawings, which are incorporated in and constitute a part of this disclosure, illustrate exemplary embodiments and, together with the description, serve to explain the disclosed principles. The same numbers are used throughout the figures to reference like features and components. Some embodiments of device and/or methods in accordance with embodiments of the present subject matter are now described, by way of example only, and with reference to the accompanying figures, in which:

**FIG. 1** illustrates a schematic representation of a rotating machine and an enlarged portion of an air gap, in which at least some embodiments of the present disclosure may be practiced;

**FIG. 2** is a block diagram of a system for determining air gap eccentricity condition in a rotating machine, in accordance with an embodiment of the present disclosure;

**FIG. 3A** illustrates external leakage flux measurements from a plurality of magnetic sensors of the rotating machine depicting a healthy rotating machine, in accordance with an embodiment of the present disclosure;

**FIG. 3B** illustrates external leakage flux measurements from a plurality of magnetic sensors of the rotating machine depicting static eccentricity in the rotating machine, in accordance with an embodiment of the present disclosure;

**FIG. 3C** illustrates external leakage flux measurements from a plurality of magnetic sensors of the rotating machine depicting a dynamic eccentricity in the rotating machine, in accordance with an embodiment of the present disclosure;

**FIG. 4A** is a flowchart illustrating a method for determining dynamic eccentricity in a rotating machine, in accordance with an embodiment of the present disclosure;

**FIG. 4B** is a flowchart illustrating a method for determining static eccentricity in a rotating machine, in accordance with an embodiment of the present disclosure; and

**FIG. 5** is a flowchart illustrating a method for determining air gap eccentricity condition in a rotating machine, in accordance with an embodiment of the present disclosure.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor, whether or not such computer or processor is explicitly shown.

## DETAILED DESCRIPTION

In the present document, the word "exemplary" is used herein to mean "serving as an example, instance, or illustration". Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the particular forms disclosed, but on the contrary, the disclosure is to cover all modifications, equivalents, and alternative falling within the spirit and the scope of the disclosure.

The terms "comprises", "comprising", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a device or system or apparatus proceeded by "comprises... a" does not, without more constraints, preclude the existence of other elements or additional elements in the device or system or apparatus.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

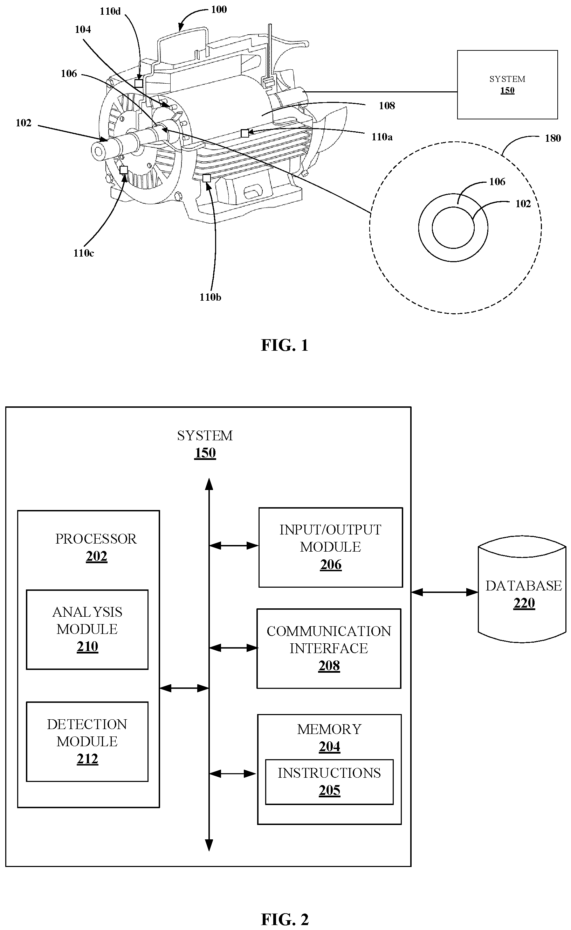

**FIG. 1** illustrates a schematic representation of a rotating machine 100, in which at least some embodiments of the present disclosure may be practiced.

The term 'rotating machine' as used herein refers to energy conversion machines which comprise a rotating component (i.e., rotor) and a stationary component (i.e., stator). As such, the rotating machine 100 includes electrical rotating machines equipped with a rotor 102 and a stator 104 separated by an air gap 106 as depicted in enlarged portion 180. The air gap 106 is an actual physical gap in the rotating machine 100 that separates the moving rotor 102 and the stator 104. In an example, any machine that performs electromechanical conversion of energy by rotational motion are rotating electric machines. The rotating machine 100 may be an Alternating Current (AC) machine or a Direct Current (DC) machine such as, electric motors, electrical generators, and the like. In this example representation, the rotating machine 100 is an induction motor used in industrial processes.

The present disclosure is explained herein with reference to a rotating electric machine such as, an induction motor shown in **FIG. 1.** It shall be noted that rotating machine 100 is interchangeably referred to hereinafter as rotating electric machine 100. However, it shall be noted that various embodiments of the present invention may be practiced with rotating machines other than the induction motor. It shall be noted that the rotating machine 100 is depicted for exemplary purposes and the rotating machine 100 may include fewer or more components than those depicted in **FIG. 1.** Moreover, only components of the rotating machine 100 that are essential for the present disclosure are explained herein and the description of other components of the rotating machine 100 are not provided herein for the sake of brevity.

In an example scenario, the air gap 106 shown in the enlarged portion 180, may vary in a non-uniform manner due to air gap eccentricity condition. The term 'air gap eccentricity' as used herein refers to a condition that occurs when there is a non-uniform or asymmetric distance between rotor 102 and the stator 104 in an air gap 106 of a rotating machine 100. When there is an eccentricity in the air gap 106, a permeance in the air gap 106 varies, causing unbalanced magnetic flux within the air gap 106. Air gap eccentricity condition may be at least one of: a static eccentricity, and a dynamic eccentricity. When radial air gap is fixed to a minimum at a same position of the air gap 106 with respect to the stator 104 irrespective of rotor movement, then static eccentricity occurs. Static eccentricity may be caused due to stator core ovality, incorrect positioning of stator core or bearing at commissioning or during repair, and its level does not change over time. Dynamic eccentricity is a condition where the location of the minimum radial air gap is not confined to one location as in the static eccentricity but rotates with the rotor 104. In other words, the center of the rotor 104 is not at the center of rotation but moves that increases/decreases the air gap 106 at different locations. This is produced by bent shaft, worn bearings, asymmetric thermal expansion of the rotor 104 etc. When the rotating machine 100 experiences both a static eccentricity and a dynamic eccentricity, then such an air gap eccentricity condition is referred to as mixed eccentricity. For example, wear or cracks in rotor may introduce mixed air gap eccentricity condition in the rotating machine 100.

In an embodiment, one or more magnetic sensors 110 (shown in **FIG. 1** as 110a, 110b, 110c, 110d and collectively referred to as 'one or more magnetic sensors 110') are used for measuring the external leakage flux. The external leakage flux is a part of magnetic flux generated from the rotating machine 100 that do not follow a desired path in a magnetic circuit and is also referred to as stray flux. As such, generation of external leakage flux is inherent nature of rotating machines such as, the rotating machine 100 (shown in **FIG. 1**) due to existing air gap 106 between the stator 104 and the rotor 102 of the rotating machine 100. It shall be noted that the term 'external leakage flux measurements' as used herein refers to the leakage flux external to the rotating machine 100 and not to leakage flux/magnetic flux within the air gap 106. This external leakage flux measurements may be used to determine eccentricity condition of the air gap 106 of the rotating machine 100. Typically, when there is a change in the air gap 106 of the rotating machine 100, leakage reactance between the stator 104 and the rotor 102 also varies and thus external leakage flux of the rotating machine 100 also fluctuates to indicate this change in the air gap 106 of the rotating machine 100. As such, air gap eccentricity condition of rotating machines that are electrical (i.e., the rotating electric machine 100) may be determined by measuring the external leakage flux of the rotating machine 100.

In an embodiment, each magnetic sensor 110a, 110b, 110c, 110d of the one or more magnetic sensors 110 may be used to receive external leakage flux measurements around the rotating machine 100. The one or more magnetic sensors 110 may be analog sensors or digital sensors (e.g., MEMS-based magnetic sensors).

In an embodiment, the one or more magnetic sensors 110 are proximate to the rotating machine 100 to receive the external leakage flux measurements of the rotating machine 100 for determining the eccentricity condition of the rotating machine 100. More specifically, each magnetic sensor of the one or more magnetic sensors 110 may be arranged at different locations proximate to the rotating machine 100 for measuring the external leakage flux measurements. In an embodiment, the magnetic sensors 110a, 110b, 110c are disposed on a body 108 of the rotating machine 100 as shown in **FIG. 1.** It shall be noted that in some existing rotating electrical machines such as, the rotating machine 100, include magnetic field sensors such as the magnetic sensor 110a on the body 108 of the rotating machine 100 which may be used for capturing the external leakage flux measurements. In an example, the magnetic sensor 110a mounted on the body of the rotating machine 120 is used for monitoring condition of the rotating machine 120, for example, to identify broken rotor bars of the rotating machine 100. In an embodiment, the magnetic sensor 110a may be adapted to also measure the external leakage flux generated from the rotating machine 100. It shall be noted that although only one magnetic sensor 110a is depicted to be mounted on the body 108 of the rotating machine 100, more than one magnetic sensor, for example, the magnetic sensors 110b, 110c, 110d may be mounted at a plurality of different locations of the body 108 of the rotating machine 100 and at a plurality of different angles of the rotating machine 100 for measuring the external leakage flux generated by the rotating machine 100.

In an example, the magnetic sensors 110a, 110b, 110c, 110d are mounted on a frame of the rotating machine 100 and are distributed uniformly, i.e., if there are three sensors 110a, 110b, 110c, then each of the magnetic sensors will be placed 120 degrees apart on the circumference of the frame, if there are 4 magnetic sensors 110a, 110b, 110c, 110d, then the magnetic sensors 110, 110b, 110c, 110d are placed 90 degrees apart. In another example, the magnetic sensor 110a may be mounted anywhere on end shields of the rotating machine 100, the magnetic sensor 110b may be mounted anywhere on a frame of the rotating machine 100, the magnetic sensor 110c is mounted within a seal housing of a compressor. It shall be noted that the examples described herein for exemplary purposes and in general, the one or more magnetic sensors 110 may be adapted to be mounted at any location of the rotating machine 110 or proximate to the rotating machine 100 and at any direction subject to receiving the external leakage flux measurements generated by the rotating machine 100 for processing and determining the air gap eccentricity condition of the rotating machine 100. In this example representation, magnetic sensors 110a, 110b, and 110d are shown on a surface (i.e., frame/rim) of the rotating machine 100 and the magnetic sensor 110c is shown on the end cover of the rotating machine 100, It shall be noted that the magnetic sensors 110a, 110b, 110c and 110d may be mounted anywhere on the rotating machine 100 or adapted to be mounted proximate to the rotating machine 100 for receiving external leakage flux measurements of the rotating machine 100. However, it shall be noted that the magnetic sensors 110a, 110b, 110c and 110d are not placed or mounted anywhere near the air gap 106 as they are non-intrusive sensors which measure external leakage flux external to the air gap 106 of the rotating machine 100.

In this example representation, magnetic sensors 110a, 110b and 110d are mounted on outer surface i.e., frame, of the rotating machine and the magnetic sensor 110c is mounted on end cover of the rotating machine 100. It shall be noted that when a plurality of magnetic sensors, for example, the magnetic sensors 110a, 110b, 110c and 110d are used, the external leakage flux measurements from the magnetic sensors 110a, 110b, 110c, 110d may be analyzed separately to determine the air gap eccentricity in the rotating machine 100.

Various embodiments of the present disclosure, disclose a system 150 for air gap eccentricity detection in rotating machines. In general, the system 150 uses signal processing to analyze the external leakage flux measurements received from the one or more magnetic sensors 110. A moving average is determined from each of the external leakage flux measurements and air gap eccentricity condition is determined based on the moving average of each of the external leakage flux measurements. Further, the system 150 is also configured to determine type of the air gap eccentricity based on the moving average. In addition, a severity level of the air gap eccentricity condition may be determined for providing notifications which may help schedule maintenance and take timely actions. Moreover, a control signal may be generated based on customer settable severity level of the fault for actuating a circuit breaker electrically coupled to the rotating machine 100. The processing of the external leakage flux measurements by the system 150 is explained next with reference to **FIGS. 2-5.**

**FIG. 2** illustrates the system 150 for determining air gap eccentricity in the rotating machine 100, in accordance with an embodiment of the present disclosure. In an embodiment, the system 150 is a standalone processor embodied within a control system capable of controlling the operations of an industrial process in which the rotating machine 120 is used. More specifically, the system 150 is a relay which works in real-time to trip the circuit breaker of the rotating machine 100 based on customer settable severity level of the fault as will be explained later. In another embodiment, the system 150 is a control system capable of controlling the rotating machine 120. In yet another example, the system 150 is a general purpose computer configured to perform the operations as described herein.

The system 150 is depicted to include a processor 202, a memory 204, an Input/Output module 206, and a communication interface 208. It shall be noted that, in some embodiments, the system 150 may include more or fewer components than those depicted herein. The various components of the system 150 may be implemented using hardware, software, firmware or any combinations thereof. Further, the various components of the system 150 may be operably coupled with each other. More specifically, various components of the system 150 may be capable of communicating with each other using communication channel media (such as buses, interconnects, etc.). It is also noted that one or more components of the system 150 may be implemented in a single server or a plurality of servers, which are remotely placed from each other.

In one embodiment, the processor 202 may be embodied as a multi-core processor, a single core processor, or a combination of one or more multi-core processors and one or more single core processors. For example, the processor 202 may be embodied as one or more of various processing devices, such as a coprocessor, a microprocessor, a controller, a digital signal processor (DSP), a processing circuitry with or without an accompanying DSP, or various other processing devices including, a microcontroller unit (MCU), a hardware accelerator, a special-purpose computer chip, or the like.

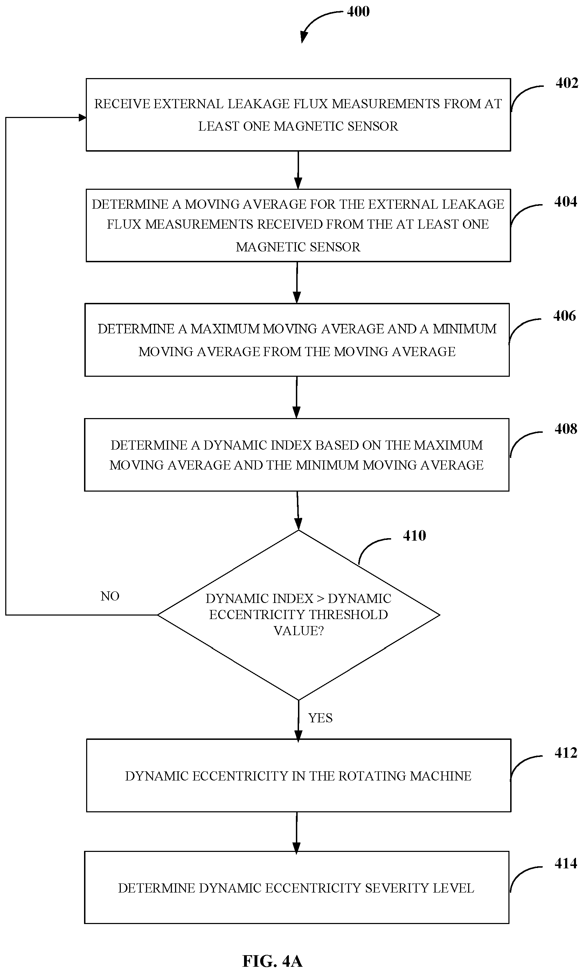

In one embodiment, the memory 204 is capable of storing machine executable instructions, referred to herein as instructions 205. In an embodiment, the processor 202 is embodied as an executor of software instructions. As such, the processor 202 is capable of executing the instructions 205 stored in the memory 204 to perform one or more operations described herein. The memory 204 can be any type of storage accessible to the processor 202 to perform respective functionalities, as will be explained in detail with reference to **FIGS. 4A-4B.** For example, the memory 204 may include one or more volatile or non-volatile memories, or a combination thereof. For example, the memory 204 may be embodied as semiconductor memories, such as flash memory, mask ROM, PROM (programmable ROM), EPROM (erasable PROM), RAM (random access memory), etc. and the like.

In an embodiment, the processor 202 is configured to execute the instructions 205 for: (1) determining a moving average for the external leakage flux measurements received from each of the plurality of magnetic sensors 110a, 110b, 110c, 110d, (2) determining an air gap eccentricity condition of the rotating machine 100 based on the moving average associated with each of the plurality of magnetic sensors 110a, 110b, 110c, 110d, (3) determining a maximum moving average and a minimum moving average from the moving average associated with the external leakage flux measurements from at least one magnetic sensor of the plurality of magnetic sensors 110a, 110b, 110c, 110d, (4) determining a dynamic index based on the maximum moving average and the minimum moving average, (5) determining the air gap eccentricity condition as a dynamic eccentricity when the dynamic index is greater than a dynamic eccentricity threshold value, (6) determining a dynamic eccentricity severity level based on the dynamic index, (7) determining a plurality of flux density distributions based on the moving average for the external leakage flux measurements received from each of the plurality of magnetic sensors 110a, 110b, 110c, 110d, (8) identifying a least flux density distribution from the plurality of flux density distributions as a first reference flux density distribution and a maximum flux density distribution from the plurality of flux density distributions as a second reference flux density distribution, (9) determining a plurality of flux density distribution distances based on the plurality of flux density distributions, the first reference flux density distribution and the second reference flux density distribution, (10) determining a distribution difference between each of the plurality of flux density distribution distances at a current time instant and a previous time instant, (11) determining a static index based on the plurality of flux density distribution distances and the distribution difference, (12) determining the air gap eccentricity condition as a static eccentricity when the static index is greater than a static eccentricity threshold value, (13) determining the air gap eccentricity condition as a static eccentricity when the static index is greater than a static eccentricity threshold value, (14) determining a static eccentricity severity level based on the density distribution difference. The processor 202 may further be configured to execute the instructions 205 to: (1) generate a control signal based on at least one of: the dynamic eccentricity severity level and the static eccentricity severity level, and (2) generate a notification based on determining the air gap eccentricity condition of the rotating machine 100.

In an embodiment, the I/O module 206 may include mechanisms configured to receive inputs from and provide outputs to an operator of the system 150. The term 'operator of the system 150' as used herein may refer to one or more individuals, whether directly or indirectly, associated with managing the rotating machine 100. To enable reception of inputs and provide outputs to the system 150, the I/O module 206 may include at least one input interface and/or at least one output interface. The I/O module 206 may be used by the operator of the system 150 to provide a dynamic eccentricity threshold value, a static eccentricity threshold value and customer settable severity levels of the fault for actuating a circuit breaker via the input interface. In an example, the severity levels (i.e., dynamic eccentricity severity level and the static eccentricity severity level) may be displayed to the operator of the system 150. Further, a notification based on determining the air gap eccentricity condition of the rotating machine 100, type of air gap eccentricity condition, and severity level may also be displayed in the output interface. In some embodiments, an alarm may be initiated based on the severity level of the air gap eccentricity condition using the output interfaces. Such warnings based on the customer settable severity levels are highly important to reduce the damages and undertake a planned maintenance of the rotating machine 100.

Examples of the input interface may include, but are not limited to, a keyboard, a mouse, a joystick, a keypad, a touch screen, soft keys, a microphone, and the like. Examples of the output interface may include, but are not limited to, a display such as a light emitting diode display, a thin-film transistor (TFT) display, a liquid crystal display, an active-matrix organic light-emitting diode (AMOLED) display, a microphone, a speaker, a ringer, and the like.

The communication interface 208 may include mechanisms configured to communicate with external entities/peripheral devices, for example, the one or more magnetic sensors 110a, 110b, 110c, 110d associated with the rotating machine 100, remote servers, etc. In other words, the communication interface 208 is configured to receive the external leakage flux measurements from each magnetic sensor of the one or more magnetic sensors 110 for processing by the processor 202. As already explained, the external leakage flux measurements are made by the one or more magnetic sensors 110 mounted on the rotating machine 100 or placed proximal to the body 108 of the rotating machine 100 so as to measure the external leakage flux of the rotating machine 100. In an embodiment, the external leakage flux measurements are forwarded to the processor 202 which performs one or more operations described herein to detect air gap eccentricity in the rotating machine 100. It shall be noted that the external leakage flux measurements received from the one or more magnetic sensors 110 may be conditioned prior to processing by the processor 202. Accordingly, the system 150 may include other components for pre-processing the external leakage flux measurements received from the one or more magnetic sensors 110, for example, a signal conditioner (not shown in **FIG. 2**). In general, signal conditioning is a process of manipulating an analog signal (here the 'magnetic flux measurement') in such way that it is optimized for further processing. As such, signal conditioning of the magnetic flux measurement may include, but not limited to, amplification, filtering, amplifying, converting, range matching, isolation and any other processes required to make sensor outputs from the magnetic sensors suitable for processing after conditioning. In general, such signal conditioning of the magnetic flux measurement may be performed to eliminate undesired noise, increasing resolution, increasing Signal-to-Noise Ratio (SNR), conversion to other form, and the like. In an embodiment, the external leakage flux measurements of each of the plurality of magnetic sensors 1 10a, 110b, 110c, 110d are Direct Current (DC) components. More specifically, a moving average filter is used part of pre-processing to generate the DC components of the external leakage flux measurements which may be processed further to detect air gap eccentricity and severity level of the air gap eccentricity in the rotating machine 100. In another embodiment, the external leakage flux measurements of each of the plurality of magnetic sensors

110a, 110b, 110c, 110d include Alternating Current (DC) components.

The system 150 is depicted to be in operative communication with a database 220. In one embodiment, the database 220 is configured to store one or more machine parameters related to the rotating machines managed by the system 150. Some examples of machine parameters include, but not limited to, air gap measurements, rotor specifications, stator specifications, etc. The database 220 may include multiple storage units such as hard disks and/or solid-state disks in a redundant array of inexpensive disks (RAID) configuration. In some embodiments, the database 220 may include a storage area network (SAN) and/or a network attached storage (NAS) system. In one embodiment, the database 220 may correspond to a distributed storage system, wherein individual databases are configured to store custom information, such as air gap eccentricity monitoring policies, list of rotating machines, air gap eccentricity condition of rotating machines over time, details of fault conditions, severity levels, maintenance data, historical data of external leakage flux measurements, dynamic eccentricity threshold values, static eccentricity threshold values, notifications, etc.

In some embodiments, the database 220 is integrated within the system 150. For example, the system 150 may include one or more hard disk drives as the database 220. In other embodiments, the database 220 is external to the system 150 and may be accessed by the system 150 using a storage interface (not shown in **FIG. 2**). The storage interface is any component capable of providing the processor 202 with access to the database 220. The storage interface may include, for example, an Advanced Technology Attachment (ATA) adapter, a Serial ATA (SATA) adapter, a Small Computer System Interface (SCSI) adapter, a RAID controller, a SAN adapter, a network adapter, and/or any component providing the processor 302 with access to the database 220.

As already explained, the communication interface 208 is configured to receive the external leakage flux measurements from each magnetic sensor of the one or more magnetic sensors 110 and forwards the magnetic flux measurements to the processor 202. The processor 202 in conjunction with the instructions in the memory 204 are configured to process the external leakage flux measurements for air gap eccentricity detection in the rotating machine 100. As already explained the external leakage flux measurements may correspond to the leakage flux generated by the rotating machine 100 (i.e., a rotating electrical machine) due to changes in the air gap 106 between the stator 104 and the rotor 102 of the rotating machine 100. It shall be noted that the external leakage flux measurements are captured external to the rotating machine 100 and nowhere do the one or more magnetic sensors 100 measure the external leakage flux in the air gap 106 of the rotating machine 100.

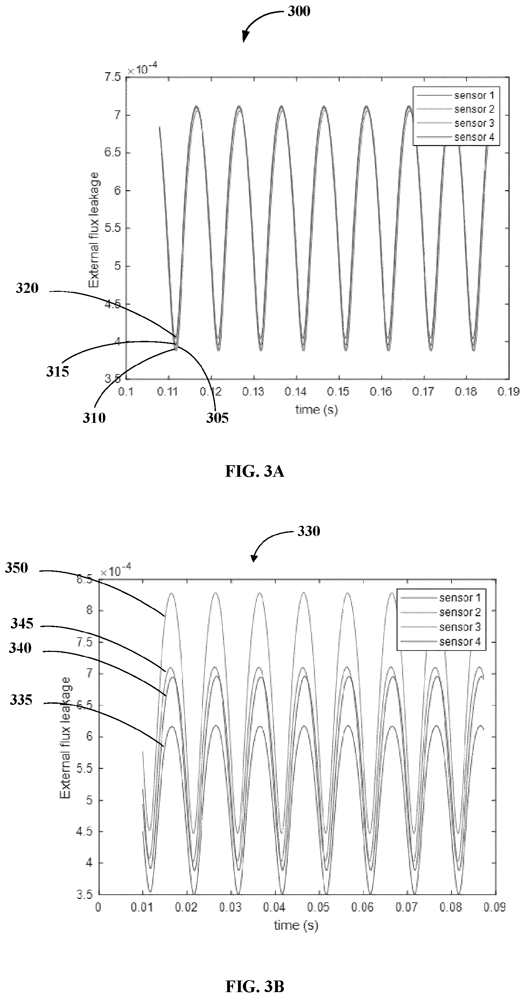

More specifically, the external leakage flux measurements may be used to identify air gap eccentricity conditions in the rotating machine 100. Mostly, eccentricity conditions in the rotating machine 100 arise due to excessive wear, manufacture/installation error, extreme operating conditions which result in imbalances causing the air gap 106 between the stator 104 and the rotor 102 to vary. As such, these eccentricity conditions may cause increased mechanical vibration, accelerated insulation degradation due to increased coil movement, and possible rotor 102/stator 104 rubbing due to unbalanced magnetic pull and in extreme cases the rotor 104 may touch the stator 102 causing a catastrophic failure. Some examples of the air gap eccentricity conditions in the rotating machine 100 include, but not limited to, static eccentricity, dynamic eccentricity, and mixed eccentricity. Examples of the external leakage flux measurements from the one or more magnetic sensors 110 depicting different types of eccentricity conditions are shown and explained next with reference to **FIGS. 3A-3C.**

Referring now to **FIG. 3A,** a plot 300 depicts external leakage flux measurements from the magnetic sensors 110a, 110b, 110c and 110d of the rotating machine 100 depicting a healthy air gap, in accordance with an embodiment of the present disclosure. In an example, the external leakage flux measurements shown in the plot 300 may be captured by the one or more magnetic sensors 110a, 110b, 110c, and 110d as soon as the rotating machine 100 is installed. In this example representation, the external leakage flux measurements from the magnetic sensor 110a are shown by plot 305, the external leakage flux measurements from the magnetic sensor 110b are shown by plot 310, the external leakage flux measurements from the magnetic sensor 110c are shown by plot 315 and the external leakage flux measurements from the magnetic sensor 110d are shown by plot 320. It shall be noted that the plot 300 depicting an healthy air gap 100 (i.e., air gap with no eccentricity condition) of the rotating machine 100 right after installation of the rotating machine 100 is for exemplary purposes and the air gap 106 of the rotating machine 100 may be healthy indicating no eccentricity condition even after years of operation.

As can be seen from **FIG. 3A,** the external leakage flux measurements from the magnetic sensors 110a, 110b, 110c and 110d vary with time in a uniform manner and as such, there is no air gap eccentricity deciphered from the plots 305, 310, 315, and 320. As already explained, when there is a change in the air gap 106 of the rotating machine 100, leakage reactance between the stator 104 and the rotor 102 also varies and thus external leakage flux measurements of the rotating machine 100 from some of the magnetic sensors (e.g., 110a, 110b) may deviate from other magnetic sensors (110c, 110d) to indicate this change in the air gap 106 of the rotating machine 100. However, as there are no changes in the air gap 106 of the rotating machine 100, the external leakage flux measurements are appear uniform in the plots 305, 310, 315 and 320. However, if the air gap 106 of the rotating machine 100 is non-uniform, then the external leakage flux measurements shown by plots 305, 310, 315 and 320 vary to indicate the air gap eccentricity as will be explained next with reference to **FIGS. 3B-3C.**

Referring now to **FIG. 3B,** external leakage flux measurements from magnetic sensors 110a, 110b, 110c, and 110d depicting static eccentricity in the rotating machine 100 are illustrated in accordance with an embodiment of the present disclosure. In an example, the external leakage flux measurements shown in plot 330 may be captured by the one or more magnetic sensors 110a, 110b, 110c, and 110d as soon as the rotating machine 100 is installed. For example, a misalignment during motor assembly may result in an uneven air gap between the rotor 104 and the stator 102 which is stationary with respect to the stator 104 of the rotating machine 100.

In this example representation, the external leakage flux measurements from the magnetic sensor 110a are shown by plot 335, the external leakage flux measurements from the magnetic sensor 110b are shown by plot 340, the external leakage flux measurements from the magnetic sensor 110c are shown by plot 345 and the external leakage flux measurements from the magnetic sensor 110d are shown by plot 350. It shall be noted that the plot 330 depicting static eccentricity in the rotating machine 100 right after installation of the rotating machine 100 is for exemplary purposes and the static eccentricity in the air gap 106 may arise due to worn out bearings in the stator 104 of the rotating machine 100.

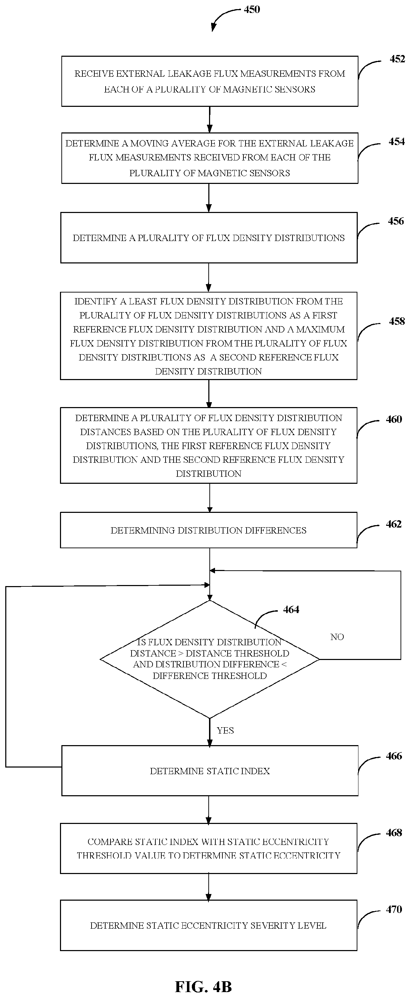

As can be seen from **FIG. 3B,** the external leakage flux measurements from the magnetic sensors 110a, 110b, 110c and 110d show different distributions. For example, external leakage flux measurements from magnetic sensor 110d shows a greater spread/distribution (see, plot 350) compared to external leakage flux measurements from the other magnetic sensors 110a, 110b, 110c (see, plots 335, 340, 345). The external leakage flux measurements from the magnetic sensors 110a, 110b, 110c and 110d appear uniform but have different distributions indicating a static eccentricity of the air gap 106 in the rotating machine 100. In general, when the external leakage flux measurements from each magnetic sensor varies uniformly with respect to time but their distribution indicates that the external leakage flux measurements of each of the magnetic sensors 110a, 110b, 110c, 110d are spread out in the plot 330 indicating static eccentricity. In general, when there is an increase/decrease in the air gap 106 of the rotating machine 100 at a specific position, leakage reactance between the stator 104 and the rotor 102 also varies based on the position and as such, the external leakage flux measurements of the rotating machine 100 from one magnetic sensor (e.g., magnetic sensor 110d) may have a different distribution to show the increase or decrease in the air gap 106. It shall be noted that for detecting static eccentricity in the air gap 106 of the rotating machine 100, external leakage flux measurements from a plurality of magnetic sensors (i.e., at least three magnetic sensors 110a, 110b, 110c) are required for determining the distribution or spread as will be explained in detail with reference to **FIG. 4B.**

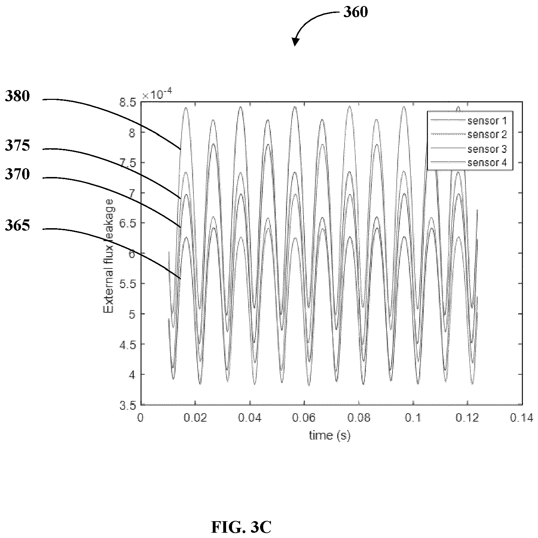

Referring now to **FIG. 3C,** external leakage flux measurements from the magnetic sensors 110a, 110b, 110c, 110d depicting dynamic eccentricity in the rotating machine 100 are illustrated in accordance with an embodiment of the present disclosure. As already explained, dynamic eccentricity is a condition in the rotating machine 100 where the center of the rotor 102 is not at the center of rotation and position of the minimum radial air gap rotates with the rotor 102. As such, the external leakage flux measurements fluctuates with the change in the air gap 106 due to the dynamic eccentricity.

In this example representation, the external leakage flux measurements from the magnetic sensor 110a are shown by plot 365, the external leakage flux measurements from the magnetic sensor 110b are shown by plot 370, the external leakage flux measurements from the magnetic sensor 110c are shown by plot 375 and the external leakage flux measurements from the magnetic sensor 110d are shown by plot 380. It shall be noted that the plots 365, 370, 375 and 380 are shown for exemplary purposes and the plots may vary in a different manner from those depicted herein to indicate dynamic eccentricity. It shall be noted that external leakage flux measurements from a single magnetic sensor (e.g., magnetic sensor 110a) may be used for determining dynamic eccentricity. More specifically, fluctuations shown by one magnetic sensor may be used for determining variance in the external leakage flux measurements and this variance may be used to identify dynamic eccentricity of the rotating machine 100.

As can be seen from **FIG. 3C,** the external leakage flux measurements from the magnetic sensors 110a, 110b, 110c and 110d vary with time in a non-uniform manner. More specifically, the external leakage flux measurements from the magnetic sensor 110a show significant fluctuations in their maximum value and minimum value observed over a time period (*see,* plot 365). For example, maximum values ($v_{max1}$, $v_{max2}$, $v_{max3}$, ...) and minimum values ($v_{min1}$, $v_{min2}$, $v_{min3}$, ...) of the external leakage flux measurements are not uniform as in the rotating machine 100 with a healthy air gap 106 shown in **FIG. 3A.** Such significant fluctuations in the external leakage flux measurements (i.e., maximum and minimum values of external leakage flux measurements) of the magnetic sensor 110a indicate dynamic eccentricity in the rotating machine 100. The plots 370, 375 and 380 of **FIG. 3C** show similar fluctuations and fluctuations shown in external leakage flux measurements of one magnetic sensor such as, the magnetic sensor may be sufficient to determine the dynamic eccentricity condition. As such, if the system 150 is implemented to only measure dynamic eccentricity condition in the rotating machine 100, the external leakage flux measurements from a single magnetic sensor would suffice to detect dynamic eccentricity in the air gap 106 of the rotating machine 100. In general, as the minimum radial air gap rotates with the rotor 102 in dynamic eccentricity, the air gap 106 in the rotating machine 100 increases/decreases with rotation of the rotor at different positions which causes leakage reactance between the stator 104 and the rotor 102 to fluctuate based on the minimal air gap position and as such, the external leakage flux measurements of the rotating machine 100 from one magnetic sensor (e.g., magnetic sensor 110a) may show a significant variance (i.e., difference between maximum values and minimum values of the external leakage flux measurements) indicating dynamic eccentricity condition in the rotating machine 100. The processing of these external leakage flux measurements to determine the air gap eccentricity condition is explained with reference to **FIG. 2.**

Referring now to **FIG. 2,** the processor 202 receives the external leakage flux measurements and performs analysis to determine air gap eccentricity condition of the rotating machine 100 as will be explained hereinafter.

In an embodiment, the processor 202 is configured to determine a moving average for the external leakage flux measurements received from each of the plurality of magnetic sensors 101a, 101b, 101c and 101d. More specifically, the external leakage flux measurements from each magnetic sensor (e.g., magnetic sensor 110a) may be analyzed in smaller windows, for example, windows of 20 msec. As such, the moving average of external leakage flux measurements from a magnetic sensor (e.g., magnetic sensor 110a) comprises a series of averages ($a_1$, $a_2$, $a_3$, ....) of different selections of the external leakage flux measurements. In general, the external leakage flux measurements analyzed are in smaller windows that are also referred to herein as 'windowed signal'. In an embodiment, these smaller windows are overlapping windows. In an example, the moving average of the external leakage flux measurement is given by equation (1) shown below.

$$LF_{MA}(n, k) = \frac{\left(\sum_{i=n-Ns+1}^{n} LF(i,k)\right)}{Ns} \quad (1)$$

where, $LF(i,k)$ is the leakage flux measurement at $i^{th}$ instant from the external sensor 'k' and 'Ns' is the number of samples in a power cycle.

In an embodiment, an air gap eccentricity condition of the rotating machine 100 is determined based on the moving average associated with each of the plurality of magnetic sensors 110a, 110b, 110c, 110d. In an example, if the series of averages ($a_1$, $a_2$, $a_3$, .... $a_n$) of different sections of the external leakage flux measurements received from a magnetic sensor (e.g., magnetic sensor 110a) is same as the series of averages ($b_1$, $b_2$, $b_3$, .... $b_n$) of corresponding sections of the external leakage flux measurements received from another magnetic sensor (e.g., magnetic sensor 110b), then there exists no air gap eccentricity condition in the rotating machine 100. It shall be noted that when the moving averages of two magnetic sensors (i.e., magnetic sensors 110a, 110b) are compared, slight variations in the moving averages may be acceptable due to relative positioning of the magnetic sensors on the rotating machine 100.

However, if the series of averages ($a_1$, $a_2$, $a_3$, .... $a_n$) of different sections of the external leakage flux measurements received from a magnetic sensor (e.g., magnetic sensor 110a) significantly differ within themselves and/or from the series of averages ($b_1$, $b_2$, $b_3$, .... $b_n$) of corresponding sections of the external leakage flux measurements received from another magnetic sensor (e.g., magnetic sensor 110b), then there exists an air gap eccentricity condition in the rotating machine 100. Accordingly, the processor 202 is configured to further analyze the moving averages of each of the plurality of magnetic sensors 1 10a, 110b, 110c, and 110d to determine the type of eccentricity condition. As already explained, the air gap eccentricity condition may be determined as one of: dynamic eccentricity, static eccentricity or mixed eccentricity. The processing of the external leakage flux measurements to determine dynamic eccentricity in the rotating machine 100 is explained hereinafter.

In an embodiment, the processor 202 is configured to determine a maximum moving average ($maxLF_{MA}(n, k)$) and a minimum moving average ($minLF_{MA}(n, k)$) from the moving average associated with the external leakage flux measurements from at least one magnetic sensor of the plurality of magnetic sensors 110a, 110b, 110c, 110d. As already explained, the moving average of external leakage flux measurements from a single magnetic sensor (e.g., magnetic sensor 110a) may be sufficient to determine dynamic eccentricity. In an example, if the leakage flux measurements from the magnetic sensor 110a are considered, then a maximum moving average (i.e., $maxLF_{MA}(n, k) = a_{max}$) and the minimum moving average (($minLF_{MA}(n, k)) = a_{min}$) are determined from the series of averages $a_1$, $a_2$, $a_3$, .... $a_n$ (i.e., moving average determined from the external leakage flux measurements of the magnetic sensor 110a). In an embodiment, the maximum moving average and the minimum moving average are determined based on the equations (2) and (3), respectively.

$$maxLF_{MA}(n, k) = \max\left(maxLF_{MA}(n - 1, k), LF_{MA}(n, k)\right) \quad (2)$$

$$minLF_{MA}(n, k) = \min\left(minLF_{MA}(n - 1, k), LF_{MA}(n, k)\right) \quad (3)$$

In an embodiment, the processor 202 is configured to determine a dynamic index based on the maximum moving average ($maxLF_{MA}(n, k)$) and the minimum moving average ($minLF_{MA}(n, k)$). More specifically, the variance in the external leakage flux measurements is determined based on the maximum moving average and the minimum moving average determined from the external leakage flux measurements received from the magnetic sensor 1 10a. The variance in the maximum moving average and the minimum moving average indicates the dynamic index. Determining the variance in external leakage flux measurements may be determined as shown in equation (4).

$$varLF_{MA} = \frac{(maxLF_{MA}(n,k) - minLF_{MA}(n,k))}{LF_{MA}(n,k)} \tag{4}$$

However, it shall be noted that the external leakage flux measurements from each of the plurality of magnetic sensors 110a, 110b, 110c, 110d may also be analyzed separately to determine the dynamic eccentricity. More specifically, the method described hereinbefore may be used for determining the dynamic eccentricity from external leakage flux measurements made by each of the plurality of magnetic sensors 110a, 110b, 110c, 110d in the rotating machine 100. In an embodiment, the dynamic index is determined based on the maximum moving average and the minimum moving average determined from the external leakage flux measurements of each of the plurality of magnetic sensors 110a, 110b, 110c, 110d as shown by equation (5).

$$dynIndex(n) = \frac{\sum_{k=1}^{S} varLF_{MA}(n,k)}{S} \tag{5}$$

where, S is the number of external leakage flux sensors.

In an embodiment, the air gap eccentricity condition is determined as a dynamic eccentricity when the dynamic index is greater than a dynamic eccentricity threshold value. The dynamic eccentricity threshold value is a customer settable value for identifying faults in the air gap 106 of the rotating machine 100. In an example, the dynamic eccentricity threshold value may be set to 0.2. Whenever the dynamic index exceeds the dynamic eccentricity threshold value (*e.g.,* 0.2), the air gap eccentricity condition is determined as dynamic eccentricity in the air gap 106 of the rotating machine as shown below by equation (6). Further, if the dynamic index is less than the dynamic eccentricity threshold value (*e.g.,* 0.2), then there exists no eccentricity condition in the air gap 106 of the rotating machine 100 as may be apparent from the equation (6) shown below.

$$dynEcc(n) = \begin{cases} 1, if\ dynIndex(n) > dynamic\ eccentricity\ thershold\ value \\ 0, otherwise \end{cases} \tag{6}$$

Further, the processor 202 is configured to determine a dynamic eccentricity severity level based on the dynamic index. An example of determining the dynamic eccentricity severity level is shown below in equation (7).

$$dynSeverity(n) = 100 * dynIndex(n)\ \% \tag{7}$$

Moreover, a control signal may be generated based on based on customer settable severity level of the fault for actuating a circuit breaker electrically coupled to the rotating machine 100. More specifically, the operator of the system 150 may specify the dynamic eccentricity severity level such that faults (i.e., air gap eccentricity conditions) in the rotating machine 100 above a specified value may trigger the circuit breaker circuit to disconnect the rotating machine 100 from other circuits to prevent catastrophic failures. The processing of leakage flux measurements from the plurality of magnetic sensors 110a, 110b, 110c, 110d to determine static eccentricity is explained hereinafter.

In an embodiment, the processor 202 is configured to determine a plurality of flux density distributions based on the moving average for the external leakage flux measurements received from each of the plurality of magnetic sensors 110a, 110b, 110c, 110d. More specifically, a flux density distribution $LF_{MA}(n,1{:}S)$ is determined based on the external leakage flux measurements from a magnetic sensor, for example, the magnetic sensor 110a.

In an embodiment, a least flux density distribution and a maximum flux distribution from the plurality of flux density distributions are identified as the first reference flux density distribution and the second reference flux density distribution. More specifically, the plurality of flux density distributions ($LF_{MA}(n,1), LF_{MA}(n,2), LF_{MA}(n,3), LF_{MA}(n,4)$) from the plurality of magnetic sensors 110a, 110b, 110c, 110d, respectively, are compared against each other to identify the first reference flux density distribution (i.e., *minValSensor*) and the second reference flux density distribution (i.e., *maxValSensor*) which is represented by equation (8) shown below.

$$\begin{cases} minValSensor = min(LF_{MA}(n,1{:}S)) \\ maxValSensor = max(LF_{MA}(n,1{:}S)) \end{cases} \tag{8}$$

In an embodiment, a plurality of flux density distribution distances are determined based on the plurality of flux density distributions. More specifically, a flux density distribution distance is determined between each of the plurality of flux density distributions and each of: the first reference flux density distribution (*minValSensor*) and the second reference flux density distribution (*minValSensor*). As such, a flux density distribution distance between the first reference flux density distribution/second reference flux density distribution and each of the plurality of flux density distributions is determined based on the equation (9) shown below.

$$\begin{cases} distVal(n,1{:}S)_{least} = 100 * (LF_{MA}(n,1{:}S) - minValSensor) \\ distVal(n,1{:}S)_{max} = 100 * (LF_{MA}(n,1{:}S) - maxValSensor) \end{cases} \tag{9}$$

In an example, if the flux density distribution $LF_{MA}(n,2)$ has a least flux density distribution and $LF_{MA}(n,4)$ has maximum flux density distribution, then $LF_{MA}(n,2)$ and $LF_{MA}(n,4)$ may be identified as the first reference flux density distribution and the second reference flux density distribution difference, respectively. Thereafter, the reference flux density distributions (i.e., $LF_{MA}$ *(n,2) and* $LF_{MA}(n,4)$) are compared with each of the flux density distributions ($LF_{MA}$ *(n,1),*$LF_{MA}$ *(n,2),*$LF_{MA}(n,3)$, $LF_{MA}(n,4)$ to determine the distance values as represented below based on the first/second reference flux density distribution difference: *(i.e.,*$distVal(n,1)_{least}$, $distVal(n,2)_{least}$, $distVal(n,3)_{least}$, $distVal(n,4)_{least}$, *dist-*$Val(n,1)_{max}$, $distVal(n,2)_{max}$, $distVal(n,3)_{max}$, $distVal(n,4)_{max}$), respectively. It shall be noted that the technique described hereinabove for determining the flux density distribution distance values is for exemplary purposes and distance between the reference flux density distribution and other flux density distributions may be determined using any other statistical techniques.

In some embodiments, the plurality of flux density distribution distances may be normalized prior to further processing. In an example, each flux density distribution distance may be normalized by dividing the flux density distribution distance values with an average value. To that effect, the average value may be determined based on moving averages determined from external leakage flux measurements received from the plurality of magnetic sensors 110a, 110b, 110c, and 110d. For example, normalizing of the flux density distribution distance may be performed as shown below in equation (10).

$$distValNorm(n, 1{:}S)_{least,max} = \frac{S * distVal(n,1{:}S)_{least,max}}{\sum_{i=1}^{S} LF_{MA}(n, i)} \tag{10}$$

The processor 202 is further configured to determine a change in the normalized flux density distribution distance (i.e., delta norm) for each magnetic sensor with respect to the previous time instant (i.e., *n-1*) to determine the distribution difference.

$$distDiff(n, 1{:}S)_{least,max} = distValNorm(n,1{:}S)_{least,max} - distValNorm(n-1,1{:}S)_{least,max} \tag{11}$$

In an example, the distribution difference *distDiff(n,* 1)$_{least}$ is determined between the normalized flux density distribution distance at a time instant (*distValNorm(n,1)$_{least}$*) and a previous time instant (*distValNorm(n - 1,1)$_{least}$*) for sensor 110a. Similarly, a distribution difference between each of the plurality of flux density distribution distances at a current time instant and a previous time instant are determined.

In an embodiment, the static index (*i.e., statIndex(n)*) is a number of normalized flux density distribution distances values (*i.e.,*$distValNorm(n,1{:}S)_{least,max}$) exceeding a distance threshold while the distribution difference *distdiff* $(n, 1{:}S)_{least,max}$ is less than a difference threshold as shown below in equation (12).

$$statIndex(n) = \begin{cases} length(distValNorm(n,1{:}S)_{least,max} > distance\ threshold, if\ distDiff(n,1{:}S)_{least,max} < difference\ threshold \\ 0, otherwise \end{cases}$$

$$\tag{12}$$

In an example, distance threshold can be 5% and difference threshold can be 0.1. As such, there are a plurality of normalized flux density distribution distances (*distValNorm(n,1)$_{least}$*, *distValNorm(n,2)$_{least}$*, *distValNorm(n,3)$_{least}$*, *distValNorm(n,4)$_{least}$*,*distValNorm(n,1)$_{max}$*, *distValN orm(n,2)$_{max}$*, *distValNorm(n,3)$_{max}$*, *distValNorm(n,4)$_{max}$*) which are checked against distance threshold and a plurality of distribution differences (*distDiff(n,1)$_{least}$*,*distDiff(n,2)$_{least}$*, *distdiff* *(n,3)$_{least}$*, *distDiff(n,4)$_{least}$*, *distDiff(n,1)$_{max}$*,*distDiff(n,2)$_{max}$*, *distDiff(n,3)$_{max}$*, *distDiff(n,4)$_{max}$*) which are checked against difference threshold. In an example, the *statIndex(n)* is 1 if only *distValNorm(n,1)$_{least}$* exceeds distance threshold and the corresponding *distDiff* *(n,1)$_{least}$* is less than difference threshold.

In an embodiment, the air gap eccentricity condition is determined as a static eccentricity when the static index *statIndex(n)* is greater than a static eccentricity threshold value. Static eccentricity condition is identified in air gap 106 of the rotating machine 100 using the equation (12) shown below.

$$statEcc(n) = \begin{cases} 1, & if\ statIndex(n) \geq static\ eccentricity\ threshold\ value \\ 0, & otherwise \end{cases} \qquad (13)$$

In an example, static eccentricity threshold value can be 2.

Further, the processor 202 is configured to determine a static eccentricity severity level based on the normalized flux density distribution $distValNorm(n, 1{:}S)_{least,max}$. In an example, the static eccentricity level is a maximum value among the normalized distance value ( $distValNorm(n,1)_{least}$, $distValNorm(n,2)_{least}$, $distVdlNdrm(n,3)_{least}$, $distValNorm(n,4)_{least}$, $distValNorm(n,4)_{least}$, $distValNorm(n,1)_{max}$, $distValNorm(n,2)_{max}$, $distValNorm(n,4)_{max}$) associated with distance between the reference flux density distributions ($LF_{MA}(n,1{:}2)$, $LF_{MA}(n,4)$ ) and each of the other flux density distributions ($LF_{MA}(n,1)$, $LF_{MA}(n,2)$, $LF_{MA}(n,3)$, $LF_{MA4}(n,4)$ ). An example of determining the static eccentricity severity level is shown below in equation (14).

$$statSeverity(n) = \max(distValNorm(n,1{:}S)_{least,max}) \qquad (14)$$

Moreover, a control signal may be generated based on customer settable severity level of the static eccentricity for actuating a circuit breaker electrically coupled to the rotating machine 100. More specifically, the operator of the system 150 may specify the static eccentricity severity level such that faults (i.e., air gap eccentricity conditions) in the rotating machine 100 above a specified value may trigger the circuit breaker to disconnect the rotating machine 100 from other circuits to prevent catastrophic failures.

In an embodiment, the processor 202 is configured to forward information related to the air gap eccentricity condition in the rotating machine 100, for example, type of air gap eccentricity, severity level, to the communication interface 208. The communication interface 208 may transmit the information related to the air gap eccentricity condition to a centralized server for further analysis and action, for example, data related to type of air gap eccentricity, severity level, which may be stored and visualized in the form of reports. In another embodiment, the communication interface 208 may forward the information related to severity level of air gap eccentricity conditions in the rotating machine 100 to an alarm circuit (not shown in Figures) which generates the alarm signal based on customer settable thresholds. The alarm circuit may provide an audible or visual alert based on the air gap eccentricity condition. In another embodiment, the processor 202 may forward the information related to the air gap eccentricity condition to the I/O module 206. The I/O module 206 may display an appropriate alert based on the air gap eccentricity condition of the rotating machine 100. For example, output interfaces such as, the ringer, the speaker and the display may be used to generate the alarm signal for the operator of the system 150. In an example, severity levels may be displayed for the operator of the system 150 such that maintenance activities of the rotating machine 100 may be planned in advance.

In an embodiment, the rotating machine 100 may exhibit both static and dynamic eccentricity and in such cases, the air gap eccentricity condition is referred to as mixed eccentricity. It shall be noted that type of eccentricity condition may be determined by evaluating the external leakage flux measurements from the plurality of magnetic sensors 1 10a, 1 10b, 110c, 1 10d for both dynamic eccentricity and static eccentricity.

As already described, external leakage flux measurements from the plurality of magnetic sensors 110a, 110b, 110c, 110d may be required to determine a static eccentricity in the air gap 106 of the rotating machine 100. However, it shall be noted that if the rotating machine 100 is specifically evaluated for dynamic eccentricity, then the external leakage flux measurements of any one of the magnetic sensors of the plurality of magnetic sensors 110a, 110b, 110c, 110d would suffice. An example flowchart depicting a method for determining dynamic eccentricity in the rotating machine is shown and explained with reference to **FIG. 4A.**

**FIG. 4A** is a flowchart illustrating a method 400 for determining dynamic eccentricity in the rotating machine 100, in accordance with an embodiment of the present disclosure. As already explained, the dynamic eccentricity is a condition where the location of the minimum radial air gap is not confined to one location as in the static eccentricity but rotates with the rotor 104. As such, the dynamic eccentricity is determined by a dynamic index which is a measure of difference between the maximum moving average and minimum moving average.

At 402 of the method 400, external leakage flux measurements of the rotating machine 100 is received from at least one magnetic sensor such as, the magnetic sensor 1 10a. It shall be noted that external leakage flux measurements from a single sensor would suffice to determine dynamic eccentricity as will be explained hereinafter. If external leakage flux measurements are received from more than one magnetic sensor, then the external leakage flux measurements from each of the magnetic sensors are evaluated separately to determine presence of dynamic eccentricity in the air gap 106 of the rotating machine 100.

At 404 of the method 400, a moving average is determined for the external leakage flux measurements received from the at least one magnetic sensor 110a. The moving average is a series of averages for different sections of the external leakage flux measurements of the magnetic sensor (i.e., 110a) which are analyzed in smaller windows.

At 406 of the method 400, a maximum moving average and a minimum moving average are determined from the moving average associated with the external leakage flux measurements from the at least one magnetic sensor. For example, a maximum moving average ($maxLF_{MA}(n, k)$) and a minimum moving average ($minLF_{MA}(n, k)$) are identified from the moving average associated with the external leakage flux measurements from the magnetic sensor 110a.

At 408 of the method 400, a dynamic index is determined based on the maximum moving average and the minimum moving average. More specifically, the dynamic index is a representation of fluctuations in the external leakage flux measurements which is determined from the moving average i.e., external leakage flux measurements associated with the magnetic sensor 110. In an example, the dynamic index is determined based on equations (4) and (5). It shall be noted that the equations (4) and (5) are for exemplary purposes and any signal processing technique to determine variance or fluctuation in the external leakage flux measurements may be used to determine the dynamic index.

At 410 of the method 400, determining if the dynamic index is greater than a dynamic eccentricity threshold value. The dynamic eccentricity threshold value is a customer settable value which may be provided by the operator of the system 150.

At 412 of the method 400, determining the air gap eccentricity condition as a dynamic eccentricity when the dynamic index is greater than a dynamic eccentricity threshold value. If the dynamic index is less than the dynamic eccentricity threshold value, dynamic eccentricity is not detected in the rotating machine 100. When the dynamic index is less than the dynamic eccentricity threshold value, the system 150 continues to monitor the air gap 106 of the rotating machine 100 to detect air gap eccentricity conditions.

At 414 of the method 400, a dynamic eccentricity severity level is determined based on the dynamic index. An example of determining the dynamic eccentricity severity level is shown in equation (7). The dynamic eccentricity severity level indicates a measurement of condition of the air gap eccentricity condition (*here,* dynamic eccentricity) which may enable the operator of the system 100 to schedule maintenance and take timely actions. An example method of determining static eccentricity in the air gap 106 of the rotating machine 100 is explained next with reference to **FIG. 4B.**

**FIG. 4B** is a flowchart illustrating a method 450 for determining static eccentricity in the rotating machine 100, in accordance with an embodiment of the present disclosure.

At 452 of the method 450, external leakage flux measurements of the rotating machine 100 is received from each of the plurality of magnetic sensors 1 10a, 110b, 110c and 110d by a system such as, the system 150.

At 454 of the method 450, a moving average for the external leakage flux measurements received from each of the plurality of magnetic sensors 110a, 110b, 110c and 110d are determined.

At 456 of the method 450, a plurality of flux density distributions are determined based on the moving average for the external leakage flux measurements received from each of the plurality of magnetic sensors 110a, 110b, 110c, and 110d.

At 458 of the method 450, a least flux density distribution from the plurality of flux density distributions is identified as a first reference flux density distribution and a maximum flux density distribution from the plurality of flux density distributions is identified as a second reference flux density distribution.

At 460 of the method 450, a plurality of flux density distribution distances are determined based on the plurality of flux density distributions, the first reference flux density distribution and the second reference flux density distribution. More specifically, each flux density distribution distance is determined by comparing each of the plurality of flux density distributions and each of: the first reference flux density distribution and the second reference flux density distribution Determination of the plurality of flux density distribution distances has been explained with reference to **FIG. 2** and is not explained herein for the sake of brevity.

At 462 of the method 450, a distribution difference is determined between each of the plurality of flux density distribution distances at a current time instant and a previous time instant.

At 464 and 466 of the method 450, a static index is determined based on the plurality of flux density distribution distances (see, operation 460) and the distribution difference as explained with reference to **FIG. 2.**

At 468 of the method 450, the air gap eccentricity condition is identified as a static eccentricity when the static index is greater than the static eccentricity threshold value. If the static index is less than the static eccentricity threshold value, then there is no static eccentricity in the rotating machine 100 and the system 150 continues to evaluate the external leakage flux measurements received from each of the plurality of magnetic sensors 110a, 110b, 110c, 110d.

At 470 of the method 450, a static eccentricity severity level is determined based on the plurality of flux density distribution distances determined at operation 460. An example of determining the static eccentricity severity level is shown in equation (10) and (14).

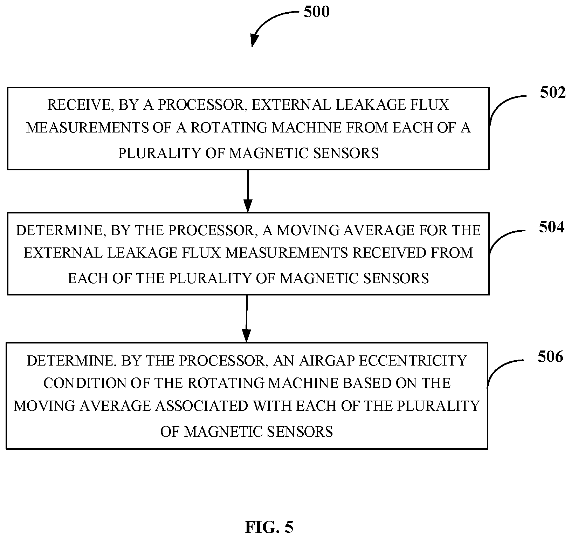

It shall be noted that although the determination of the air gap eccentricity condition in the rotating machine 100 is explained with reference to the induction motor shown in **FIG. 1,** various embodiments of the present disclosure may also be used in any other rotating machine with electrical conduction without departing from the scope of the present disclosure. More specifically, any rotating machine with an air gap and which generates leakage flux may implement embodiments consistent with the present disclosure to determined air gap eccentricity conditions. A method for determining air gap eccentricity condition in the rotating machine 100 is explained next with reference to **FIG. 5.**

**FIG. 5** is a flowchart illustrating a method 500 for determining air gap eccentricity condition in a rotating machine, in accordance with an embodiment of the present disclosure. The method 500 depicted in the flow diagram may be executed by, for example, the processor 202 shown in **FIG. 2.** Operations of the flow diagram, and combination of operations in the flow diagram, may be implemented by, for example, hardware, firmware, a processor, circuitry and/or a different device associated with the execution of software that includes one or more computer program instructions. The operations of the method 500 are described herein with help of the processor 202 of the system 150. It is noted that the operations of the method 500 can be described and/or practiced by using one or more processors of a system/device other than the processor 202. The method 500 starts at operation 502

At operation 502 of the method 500, external leakage flux measurements of a rotating machine 100 from each of a plurality of magnetic sensors 1 10a, 110b, 11c, 110d are received by a processor, such as, the processor 202 shown and explained with reference to **FIG. 2.** As already explained, the processor 302 may be embodied within a control system such as, a relay, capable of controlling the operations of an industrial process in which the rotating machine 120 is used. In another embodiment, the system 150 is a control system controlling the rotating machine 120 or maybe configured as a standalone processor configured to perform one or more of the operations described herein. In some embodiments, the processor 302 may be configured in a centralized/cloud applications, where it will receive external leakage flux measurements periodically and provide information about any evolving air gap eccentricity condition. The external leakage flux measurements are made external to the air gap 106 of the rotating machine 100 precluding the need for constructional changes which may be required in deploying the magnetic sensors 110a, 110b, 110c, 110d.

At operation 504 of the method 500, a moving average is determined for the external leakage flux measurements received from each of the plurality of magnetic sensors. More specifically, the moving average is determined as a series of averages based on external leakage flux measurements from each magnetic sensor of the plurality of magnetic sensors 110a, 110b, 110c, 110d. In an embodiment, pre-processing may be performed on the external leakage flux measurements received from each magnetic sensor to generate the DC components of the external leakage flux measurements which may be processed further to detect air gap eccentricity and severity level of the air gap eccentricity in the rotating machine 100.

At operation 506 of the method 500, an air gap eccentricity condition of the rotating machine is determined based on the moving average associated with each of the plurality of magnetic sensors. Any deviation in moving average beyond a predefined threshold, when compared within the series of average of the external leakage flux measurements associated with a magnetic sensors, such as, magnetic sensor 110a, indicates an air gap eccentricity. Similarly, any deviation in moving average when compared with moving averages of corresponding sections associated with external leakage flux measurement from another magnetic sensor (e.g., magnetic sensor 110b) indicate air gap eccentricity. Determining of the type of air gap eccentricity in the rotating machine 100 has been explained in detail with reference to FIGS. 2 and 4A-4B and is not explained herein for the sake of brevity. The type of air gap eccentricity condition and severity level of the air gap eccentricity condition may be displayed on the output interface (i.e., I/O module 206) or data (i.e., type of air gap eccentricity and severity level) related to the air gap eccentricity condition in the rotating machine 100 may also be sent to a remote server, for visualization and report generation, using a secure communication channel.

The sequence of operations of the methods 400, 450, and 500 need not be necessarily executed in the same order as they are presented. Further, one or more operations may be grouped together and performed in form of a single step, or one operation may have several sub-steps that may be performed in parallel or in sequential manner.

The disclosed method with reference to **FIG. 5,** or one or more operations of the flow diagram 400, 450 and 500 may be implemented using software including computer-executable instructions stored on one or more computer-readable media (e.g., non-transitory computer-readable media, such as one or more optical media discs, volatile memory components (e.g., DRAM or SRAM), or non-volatile memory or storage components (e.g., hard drives or solid-state non-volatile memory components, such as Flash memory components) and executed on a computer (e.g., any suitable computer, such as a laptop computer, net book, Web book, tablet computing device, smart phone, or other mobile computing device). Such software may be executed, for example, on a single local computer

Various embodiments of the present disclosure provide numerous advantages. Embodiments of the present disclosure provide a method and system for air gap eccentricity detection in rotating machines. More specifically, system receives external leakage flux measurements from only non-intrusive external sensors which measure leakage flux generated external to the air gap of the rotating machine 100. More specifically, magnetic sensors already deployed in the machine for monitoring condition of the rotating machine 100 may be used without the need for any special constructional changes unlike the intrusive sensors placed in the air gap 106 of the rotating machine 100. The disclosed method uses signal processing techniques to detect eccentricity conditions, at the same time, differentiating it from non-eccentricity conditions like rotor short circuit and stator short circuit. In general, the embodiments suggest techniques to identify the air gap eccentricity condition and type of air gap eccentricity in the rotating machine 100. Further, the method is robust and insensitive to rotor and stator shorts. Such insensitivity to rotor and stator shorts, ensures the dynamic eccentricity may be differentiated from rotor shorting and static eccentricity from stator shorting. Moreover, the system may be deployed in existing systems using a protection relay or digital solution when it is required to work in real-time. In real-time, if the system is deployed in relays, it may be configured to trip the breakers based on customer settable severity level of the fault.

Moreover, the system may also be deployed in a centralized/cloud applications, where it will receive external leakage flux measurements periodically and provide information about any evolving air gap eccentricity conditions which may result in a fault and severity of the air gap eccentricity at a given time. Further, the severity level of the air gap eccentricity may also be determined, which will help users/operators to take corrective steps well in time before the condition deteriorates. Moreover, as external leakage flux measurements are analyzed using signal processing techniques, the amount of computational resources consumed to determine the air gap eccentricity is significantly reduced when compared to the complex frequency spectrum analysis which are computationally intensive consuming significant memory and processing resources.

It will be understood by those within the art that, in general, terms used herein, and are generally intended as "open" terms (e.g., the term "including" should be interpreted as "including but not limited to," the term "having" should be interpreted as "having at least," the term "includes" should be interpreted as "includes but is not limited to," etc.). For example, as an aid to understanding, the detail description may contain usage of the introductory phrases "at least one" and "one or more" to introduce recitations. However, the use of such phrases should not be construed to imply that the introduction of a recitation by the indefinite articles "a" or "an" limits any particular part of description containing such introduced recitation to inventions containing only one such recitation, even when the introductory phrases "one or more" or "at least one" and indefinite articles such as "a" or "an" (e.g., "a" and/or "an" should typically be interpreted to mean "at least one" or "one or more") are included in the recitations; the same holds true for the use of definite articles used to introduce such recitations. In addition, even if a specific part of the introduced description recitation is explicitly recited, those skilled in the art will recognize that such recitation should typically be interpreted to mean at least the recited number (e.g., the bare recitation of "two recitations," without other modifiers, typically means at least two recitations or two or more recitations).

While various aspects and embodiments have been disclosed herein, other aspects and embodiments will be apparent to those skilled in the art. The various aspects and embodiments disclosed herein are for purposes of illustration and are not intended to be limiting, with the true scope and spirit being indicated by the following detailed description

## Claims

1. A method for determining air gap eccentricity condition in a rotating machine (100), comprising:

   receiving, by a processor (202), external leakage flux measurements of a rotating machine (100) from each of a plurality of magnetic sensors (1 10a, 110b, 110c, 110d);
   determining, by the processor (202), a moving average for the external leakage flux measurements received from each of the plurality of magnetic sensors (110a, 110b, 110c, 110d); and
   determining, by the processor (202), an air gap eccentricity condition of the rotating machine (100) based on the moving average associated with each of the plurality of magnetic sensors (110a, 110b, 110c, 110d).

2. The method as claimed in claim 1, wherein the air gap eccentricity condition is at least one of: a static eccentricity and a dynamic eccentricity.

3. The method as claimed in any of the preceding claims, wherein determining the air gap eccentricity condition of the rotating machine (100) comprises:

   determining a maximum moving average and a minimum moving average from the moving average associated with the external leakage flux measurements from at least one magnetic sensor of the plurality of magnetic sensors (110a, 110b, 110c, 110d);
   determining a dynamic index based on the maximum moving average and the minimum moving average; and
   determining the air gap eccentricity condition as a dynamic eccentricity when the dynamic index is greater than a dynamic eccentricity threshold value.

4. The method as claimed in claim 3, further comprising:
   determining a dynamic eccentricity severity level based on the dynamic index.

5. The method as claimed in any of the preceding claims, wherein determining the air gap eccentricity condition of the rotating machine comprises:

   determining a plurality of flux density distributions based on the moving average for the external leakage flux measurements received from each of the plurality of magnetic sensors (110a, 110b, 110c, 110d);

identifying a least flux density distribution from the plurality of flux density distributions as a first reference flux density distribution and a maximum flux density distribution from the plurality of flux density distributions as a second reference flux density distribution;

determining a plurality of flux density distribution distances based on the plurality of flux density distributions, the first reference flux density distribution and the second reference flux density distribution, wherein each flux density distribution distance is determined by comparing between each of the plurality of flux density distributions and each of: the first reference flux density distribution and the second reference flux density distribution;

determining a distribution difference between each of the plurality of flux density distribution distances at a current time instant and a previous time instant;

determining a static index based on the plurality of flux density distribution distances and the distribution difference; and

determining the air gap eccentricity condition as a static eccentricity when the static index is greater than a static eccentricity threshold value.

6. The method as claimed in claim 5, further comprising:
determining a static eccentricity severity level based on the plurality of flux density distribution distances.

7. The method as claimed in claims 4 or 6, further comprising:
generating, by the processor (202), a control signal based on at least one of: the dynamic eccentricity severity level and the static eccentricity severity level for actuating a circuit breaker electrically coupled to the rotating machine (100).

8. The method as claimed in any of the preceding claims, further comprising:
generating, by the processor (202), a notification based on determining the air gap eccentricity condition of the rotating machine (100).

9. A system (150) for determining air gap eccentricity condition in a rotating machine (100), comprising:

a memory (204) configured to store instructions (205); and
a processor (202) configured to execute the instructions (205) stored in the memory (204) and thereby configured to:

receive an external leakage flux measurements of a rotating machine (100) from a plurality of magnetic sensors (110a, 110b, 110c, 110d);
determine a moving average for the external leakage flux measurements received from each of the plurality of magnetic sensors (110a, 110b, 110c, 1 10d); and
determine an air gap eccentricity condition of the rotating machine (100) based on the moving average associated with each of the plurality of magnetic sensors (110a, 110b, 110c, 110d).

10. The system (150) as claimed in claim 9, wherein the air gap eccentricity condition is at least one of: a static eccentricity and a dynamic eccentricity.

11. The system (150) as claimed in any of claims 9 - 10, wherein for determining the air gap eccentricity condition of the rotating machine (100), the processor (202) is configured to:

determine a maximum moving average and a minimum moving average from the moving average associated with the external leakage flux measurements from at least one magnetic sensor of the plurality of magnetic sensors (110a, 110b, 110c, 110d);
determine a dynamic index based on the maximum moving average and the minimum moving average; and
determine the air gap eccentricity condition as a dynamic eccentricity when the dynamic index is greater than a dynamic eccentricity threshold value.

12. The system (150) as claimed in claim 11, wherein the processor (202) is further configured to:

determine a dynamic eccentricity severity level based on the dynamic index; and particularly
generate a control signal based on at least one of: the dynamic eccentricity severity level and the static eccentricity severity level for actuating a circuit breaker electrically coupled to the rotating machine (100).

13. The system (150) as claimed in any of claims 9 - 12, wherein for determining the air gap eccentricity condition of the rotating machine (100), the processor (202) is configured to:

determine a plurality of flux density distributions based on the external leakage flux measurements received from each of the plurality of magnetic sensors (110a, 110b, 110c, 110d);
identify a least flux density distribution from the plurality of flux density distributions as a first reference flux density distribution and a maximum flux density distribution from the plurality of flux density distributions as a second reference flux density distribution;
determine a plurality of flux density distribution distances based on the plurality of flux density distributions, the first reference flux density distribution and the second reference flux density distribution, wherein each flux density distribution distance is determined by comparing each of the plurality of flux density distributions and each of: the first reference flux density distribution and the second reference flux density distribution;
determine a distribution difference between each of the plurality of flux density distribution distances at a current time instant and a previous time instant;
determine a static index based on the plurality of flux density distribution distances and the distribution difference; and
determine the air gap eccentricity condition as a static eccentricity when the static index is greater than a static eccentricity threshold value.

14. The system (150) as claimed in claim 13, wherein the processor (202) is further configured to:

determine a static eccentricity severity level based on the plurality of flux density distribution distances; and particularly
generate a control signal based on at least one of: the dynamic eccentricity severity level and the static eccentricity severity level for actuating a circuit breaker electrically coupled to the rotating machine (100).

15. The system (150) as claimed in any of claims 9 - 14, wherein the processor (202) is further configured to:
generate a notification based on determining the air gap eccentricity condition of the rotating machine (100).

**FIG. 1**

**FIG. 2**

**FIG. 3A**

**FIG. 3B**

**FIG. 3C**

400

RECEIVE EXTERNAL LEAKAGE FLUX MEASUREMENTS FROM AT LEAST ONE MAGNETIC SENSOR — 402

DETERMINE A MOVING AVERAGE FOR THE EXTERNAL LEAKAGE FLUX MEASUREMENTS RECEIVED FROM THE AT LEAST ONE MAGNETIC SENSOR — 404

DETERMINE A MAXIMUM MOVING AVERAGE AND A MINIMUM MOVING AVERAGE FROM THE MOVING AVERAGE — 406

DETERMINE A DYNAMIC INDEX BASED ON THE MAXIMUM MOVING AVERAGE AND THE MINIMUM MOVING AVERAGE — 408

DYNAMIC INDEX > DYNAMIC ECCENTRICITY THRESHOLD VALUE? — 410

NO

YES

DYNAMIC ECCENTRICITY IN THE ROTATING MACHINE — 412

DETERMINE DYNAMIC ECCENTRICITY SEVERITY LEVEL — 414

**FIG. 4A**

450

RECEIVE EXTERNAL LEAKAGE FLUX MEASUREMENTS FROM EACH OF A PLURALITY OF MAGNETIC SENSORS — 452

DETERMINE A MOVING AVERAGE FOR THE EXTERNAL LEAKAGE FLUX MEASUREMENTS RECEIVED FROM EACH OF THE PLURALITY OF MAGNETIC SENSORS — 454

DETERMINE A PLURALITY OF FLUX DENSITY DISTRIBUTIONS — 456

IDENTIFY A LEAST FLUX DENSITY DISTRIBUTION FROM THE PLURALITY OF FLUX DENSITY DISTRIBUTIONS AS A FIRST REFERENCE FLUX DENSITY DISTRIBUTION AND A MAXIMUM FLUX DENSITY DISTRIBUTION FROM THE PLURALITY OF FLUX DENSITY DISTRIBUTIONS AS A SECOND REFERENCE FLUX DENSITY DISTRIBUTION — 458

DETERMINE A PLURALITY OF FLUX DENSITY DISTRIBUTION DISTANCES BASED ON THE PLURALITY OF FLUX DENSITY DISTRIBUTIONS, THE FIRST REFERENCE FLUX DENSITY DISTRIBUTION AND THE SECOND REFERENCE FLUX DENSITY DISTRIBUTION — 460

DETERMINING DISTRIBUTION DIFFERENCES — 462

IS FLUX DENSITY DISTRIBUTION DISTANCE > DISTANCE THRESHOLD AND DISTRIBUTION DIFFERENCE < DIFFERENCE THRESHOLD — 464

NO

YES

DETERMINE STATIC INDEX — 466

COMPARE STATIC INDEX WITH STATIC ECCENTRICITY THRESHOLD VALUE TO DETERMINE STATIC ECCENTRICITY — 468

DETERMINE STATIC ECCENTRICITY SEVERITY LEVEL — 470

**FIG. 4B**

*— 500*

| RECEIVE, BY A PROCESSOR, EXTERNAL LEAKAGE FLUX MEASUREMENTS OF A ROTATING MACHINE FROM EACH OF A PLURALITY OF MAGNETIC SENSORS | *— 502* |

| DETERMINE, BY THE PROCESSOR, A MOVING AVERAGE FOR THE EXTERNAL LEAKAGE FLUX MEASUREMENTS RECEIVED FROM EACH OF THE PLURALITY OF MAGNETIC SENSORS | *— 504* |

| DETERMINE, BY THE PROCESSOR, AN AIRGAP ECCENTRICITY CONDITION OF THE ROTATING MACHINE BASED ON THE MOVING AVERAGE ASSOCIATED WITH EACH OF THE PLURALITY OF MAGNETIC SENSORS | *— 506* |

**FIG. 5**

Europäisches
Patentamt

European
Patent Office

Office européen
des brevets

# EUROPEAN SEARCH REPORT

Application Number

EP 24 20 2748

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BERNIER SIMON ET AL: "Stray flux and air gap flux experimental measurement and analysis in large hydro generators", 2023 IEEE WORKSHOP ON ELECTRICAL MACHINES DESIGN, CONTROL AND DIAGNOSIS (WEMDCD), IEEE, 13 April 2023 (2023-04-13), pages 1-6, XP034337268, DOI: 10.1109/WEMDCD55819.2023.10110944 [retrieved on 2023-05-01] | 1,2, 7-10,15 | INV. G01R31/34 |
| A | * the whole document * | 3-6, 11-14 | |
| A | EP 2 653 836 A1 (ABB RESEARCH LTD [CH]) 23 October 2013 (2013-10-23) * paragraph [0032] - paragraph [0035]; figures 1a,1b,2a * | 1-15 | |
| A | VITEK O ET AL: "Detection of eccentricity and bearings fault using stray flux monitoring", DIAGNOSTICS FOR ELECTRIC MACHINES, POWER ELECTRONICS&DRIVES (SDEMPED), 2011 IEEE INTERNATIONAL SYMPOSIUM ON, IEEE, 5 September 2011 (2011-09-05), pages 456-461, XP032067913, DOI: 10.1109/DEMPED.2011.6063663 ISBN: 978-1-4244-9301-2 * the whole document * | 1-15 | TECHNICAL FIELDS SEARCHED (IPC) G01R |
| A | CN 110 531 259 A (UNIV XI AN JIAOTONG) 3 December 2019 (2019-12-03) * the whole document * | 1-15 | |

The present search report has been drawn up for all claims

| Place of search | Date of completion of the search | Examiner |
|---|---|---|
| Munich | 7 February 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 2748

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2025

| Patent document cited in search report | | Publication date | Patent family member(s) | | Publication date |
|---|---|---|---|---|---|
| EP 2653836 | A1 | 23-10-2013 | EP | 2653836 A1 | 23-10-2013 |
| | | | WO | 2013156363 A1 | 24-10-2013 |
| CN 110531259 | A | 03-12-2019 | NONE | | |

For more details about this annex : see Official Journal of the European Patent Office, No. 12/82